# EUROPEAN PATENT SPECIFICATION

(11) **EP 1 443 647 B1**
(45) Date of publication and mention of the grant of the patent: **12.09.2007**
(21) Application number: 03001720.6
(22) Date of filing: 27.01.2003
(51) Int. Cl.: H03K 5/24

(54) **Comparator and method for operating the comparator**
Komparatorschaltung und Verfahren dazu
Comparateur et son procédé d'opération

(43) Date of publication of application: 04.08.2004
(73) Proprietor: Infineon Technologies AG, 81669 München (DE)
(72) Inventor: Baglin, Thomas Jean Ludovic, 06250 Mougins le Haut (FR)
(74) Representative: Epping - Hermann - Fischer

(56) References cited:
- EP-A- 0 488 394
- WO-A-00/05814

## Description

### Technical field

The invention relates to a comparator and a method for operating the comparator. The comparator according to the invention can be used for comparing two signals and generates an comparator output signal which indicates which of the two signals is the higher one.

### Prior art

In general, the input stage of a comparator is constituted with a difference amplifier comprising a differential transistor pair with active loads (see e.g. WO 00/05814).

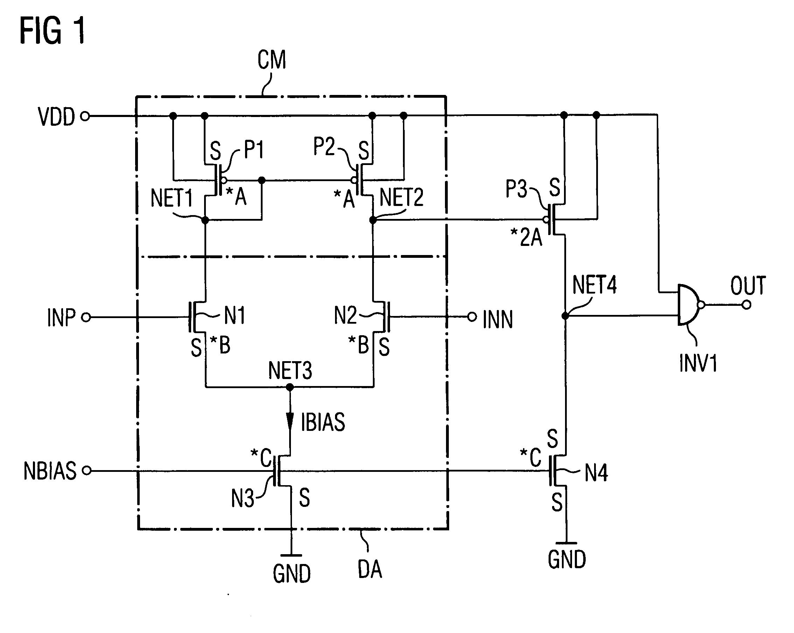

Figure 1 shows an embodiment of such a comparator circuit known from the prior art. The problem with such a design is that when both input transistors are off or non conducting, the output of the comparator can be anything, this means is undefined.

The comparator according to figure 1 has a first comparator input INP which is the non inverting input and a second comparator input INN which is the inverting input. Both comparator inputs INN and INP are connected to the control inputs of a difference amplifier transistor N1 and a difference amplifier transistor N2 of a difference amplifier DA. The difference amplifier DA further comprises a bias transistor N3 which is connected between an operating potential GND, also called ground, and the source connections of the difference amplifier transistors N1 and N2. The drain connections of the difference amplifier transistors N1 and N2 are connected to a current mirror CM comprising the current mirror transistors P1 and P2. The reference sign NET2 indicates the difference amplifier output which is placed between the drain of the difference amplifier transistor N2 and the source of the current mirror transistor P2. It leads to the control input of a transistor P3. The transistor P3 forms with a transistor N4 a serial connection which is connected between the operating potential GND and an operating potential VDD. At least an inverter INV1 is provided whose signal input is connected to the node NET4 placed between the two transistors P3 and N4 and whose power supply is the operating potential VDD. Its output forms the output OUT of the comparator. At the connector NBIAS connected to the control input of the bias transistor N3 a bias control voltage for controlling the bias current IBIAS flowing through the transistor N3 can be put. The connector NBIAS is also connected to the control input of the bias transistor N4.

In figure 1 the reference signs *A, *B *C indicate how the transistor sizes should match, wherein the size of a transistor means its width and its length. For example the size of the transistors P1, P2 and P3 should match together and the width of transistor P3 should be twice the size of the transistor widths of the transistors P1 and P2. The transistors P1, P2 and P3 should also have the same length.

The reference signs N1, N2, N3 and N4 mark the n-channel MOS or NMOS transistors while the reference signs P1, P2 and P3 mark the p-channel MOS or PMOS transistors.

The comparator circuit works as follows. When the voltages at the comparator inputs INP and INN are the same and the difference amplifier transistors N1 and N2 are in saturated region, the current flowing in branch NET1 and the current flowing in branch NET2 are the equal. Furthermore, this currents are equal to the half of the bias current IBIAS. As a consequence of it, the voltage at NET2 is equal to the voltage at NET1 and the transistor P3 tries to force a current 2 * IBIAS / 2 = IBIAS in the branch NET4. Similarly, the bias transistor N4 tries to force a bias current IBIAS in the branch NET4. The voltage at node NET4 is between VDD and 0. This shows that transistors are sized ideally to minimize the systematic offset of the comparator.

When the voltage at the non inverting comparator input INP is higher than the voltage at the inverting comparator input INN and at least one of the difference amplifier transistors N1 or N2 is on or conducting, the current flowing through the NET1 branch is greater than the current flowing through the NET2 branch. So when the current mirror constituted by the current mirror transistors P1 and P2 tries to force the current going in the NET1 branch on the NET2 branch, the voltage at node NET2 goes up. The current generated by the transistor P3 becomes lower than the current generated by the bias transistor N4 so the voltage at node NET4 goes down. The overall gain of the first and second stage is very high. Therefore, if the input voltage at the non inverting comparator input INP is only a little bit higher than the voltage at the inverting comparator input INN the voltage at node NET4 will be equal to 0. This leads that the voltage at the comparator output OUT will be equal to the operating potential VDD.

When the voltage at the inverting comparator input INN is higher than the voltage at the non inverting comparator input INP and at least one of the difference amplifier transistors N1 or N2 is on or conducting, the current flowing through the NET2 branch is higher than the current flowing through the NET1 branch. So when the current mirror transistors P1 and P2 of the current mirror try to force the current going in NET1 branch on the NET2 branch, the voltage at node NET2 goes down. The current generated by the transistor P3 becomes higher than the current generated by the bias transistor N4 so the voltage at node NET4 goes up. Because the overall gain of the first and second stage is very high, it is sufficient that the input voltage at the inverting comparator input INN is only a little bit higher than the input voltage at the non inverting comparator input INP to have the voltage at node NET4 equal to the operating potential VDD. Therefore the voltage at the comparator output OUT will be 0.

When both difference amplifier transistors N1 and N2 are switched off or non conducting because both input voltages at the comparators inputs INN and INP are low, the voltage at node NET2 is floating. Then the voltage at the comparator output OUT can be anything, this means is not defined.

To solve this problem it is possible to use a rail to rail differential input stage for the comparator but this is increasing complexity and current consumption.

### The invention

An object of the invention is to provide a comparator which delivers a defined output signal when the input signals are low and simultaneously minimizes the complexity of the circuit.

Another object of the invention is to provide a method for operating the comparator which delivers a defined output signal when the input signals are low.

An advantage of the invention is that the current consumption stays low.

The object of the invention is solved by a comparator with the features according to claim 1 and by a method for operating the comparator with the features according to the claim 8.

The comparator according to the invention comprises a difference amplifier connected to a current mirror and a series connection of a first transistor and a second transistor connected between a first and a second operating potential, wherein the control input of the first transistor is connected to the difference amplifier and the current mirror. The comparator further comprises an inverter connected to the first operating potential and to the outputs of the first and second transistor. A third transistor is connected between the second operating potential and the output of the difference amplifier wherein the control input of the third transistor is connected to the output of the inverter.

By the method for operating the comparator according to the invention the third transistor pulls the output of the difference amplifier to the second operating potential if the difference amplifier transistors are non conducting.

Advantageous further developments of the invention arise from the characteristics indicated in the dependent patent claims.

In an embodiment according to the invention the first transistor is a p-channel MOS-transistor.

In a second embodiment according to the invention the second transistor is a n-channel MOS-transistor.

In a third embodiment according to the invention the third transistor is a n-channel MOS-transistor.

Advantageously in the comparator according to the invention the difference amplifier comprises a first difference amplifier transistor and a second difference amplifier transistor, wherein the control input of the first difference amplifier transistor is connected to a first comparator input, and wherein the control input of the second difference amplifier transistor is connected to a second comparator input.

In another embodiment of the invention the control input of the second transistor is connected to a bias input. With that a bias current for the comparator can easily be adjusted.

If the current mirror of the comparator according to the invention comprises n-channel transistors and the difference amplifier comprises p-channel transistors the control input of the second transistor can be connected to a bias input.

### Brief description of the invention

Subsequently, the invention is further explained with the drawings.
- Figure 1: shows an embodiment of a comparator according to the prior art.
- Figure 2: shows an embodiment of a comparator according to the invention.
- Figure 3: shows a modified version of the comparator according to figure 2.
- Figure 4: shows a third embodiment of the comparator according to figure 2.
- Figure 5: shows a modified version of the comparator according to figure 4.

### Description of an embodiment of the invention

In the following a modification of the comparator according to figure 1 comprising a differential transistor pair with active loads is presented. By means of the modification the comparator output is set to a default value when both input transistors are switched off.

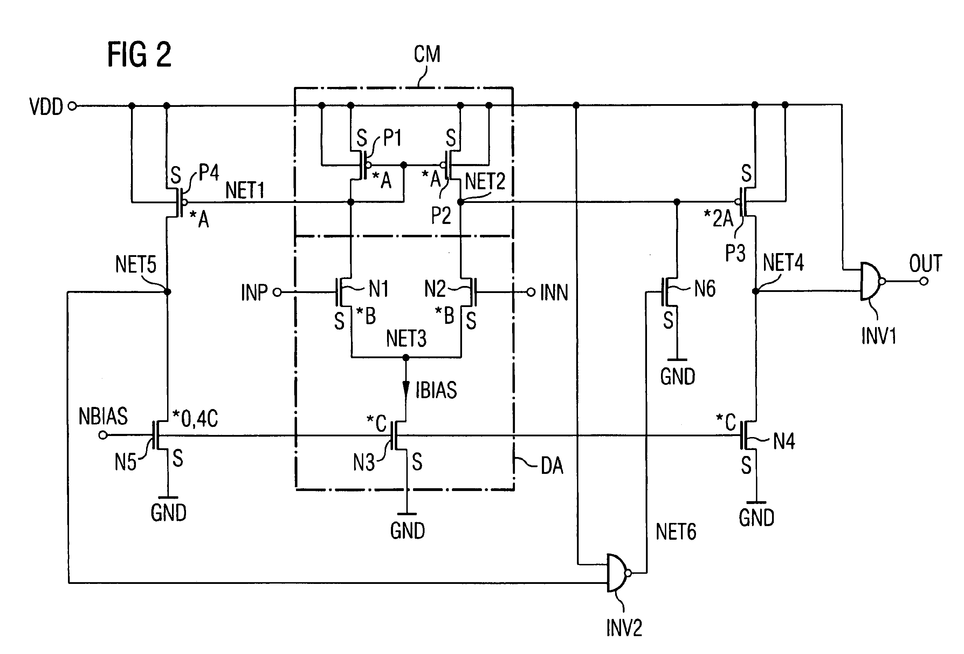

The comparator according to figure 2 has as well as the comparator shown in figure 1 a first comparator input INP which is the non inverting input and a second comparator input INN which is the inverting input. Both comparator inputs INN and INP are connected to the control inputs of a difference amplifier transistor N1 and a difference amplifier transistor N2 of a difference amplifier DA. The difference amplifier DA further comprises a bias transistor N3 which is connected between an operating potential GND, also called ground, and the source connections of the difference amplifier transistors N1 and N2. The drain connections of the difference amplifier transistors N1 and N2 are connected to a current mirror CM comprising the current mirror transistors P1 and P2. The reference sign NET2 indicates the difference amplifier output. It leads to the control input of a transistor P3. The transistor P3 forms with a second bias transistor N4 a serial connection which is connected between the operating potential GND and the operating potential VDD. At least an inverter INV1 is provided whose signal input is connected to the two transistors P3 and N4 and whose power supply is the operating potential VDD. Its output forms the output OUT of the comparator. At the connector NBIAS connected to the control input of the bias transistor N3 a bias control voltage for controlling the bias current IBIAS flowing through the bias transistor N3 can be put. The connector NBIAS is also connected to the control input of the second bias transistor N4.

In addition, the embodiment of the comparator shown in figure 2 comprises a series connection of a transistor P4 and a transistor N5 connected between the first and second operating potential VDD and GND, wherein the control input of the transistor P4 is connected to the drain of the difference amplifier transistor N1 of the difference amplifier DA and the source and gate of the current mirror transistor P1 of the current mirror CM. The comparator further comprises an inverter INV2 whose signal input is connected to the outputs of the two transistors P4 and N5 and whose power supply is the operating potential VDD. The outputs of a transistor N6 are connected between the operating potential GND and the output NET2 of the difference amplifier DA wherein the control input of the transistor N6 is connected to the output of the inverter INV2.

In Figure 2 the reference signs *A, *B, *C show how the transistor sizes should match, wherein the size of a transistor means its width and its length. In the schematic according to Figure 2, the reference sign *C means that the sizes of the transistors N3, N4, N5 should match in the following way. The width of transistor N5 should be 0.4 times the width of the transistors N3 and N4, and the lengths of the transistors N3, N4, N5 should be the same. The matching values shown in Figure 2 are just given as an indication. There are many other matching values with which the invention will work correctly.

The reference signs N1 to N6 mark the NMOS transistors while the reference signs P1 to P4 mark the PMOS transistors.

Altogether, only five transistors namely P4, N5, N6 and two transistors for the inverter INV2 are added to the comparator shown in figure 1 to reach a defined comparator output signal when both difference amplifier transistors, also called input transistors, N1 and N2 are switched off.

The comparator works as follows.

The added circuit part of the comparator circuit is a redundant path when at least one of the difference amplifier transistors N1 and N2 is conducting.

When the voltage at the non inverting comparator input INP is higher than the voltage at the inverting comparator input INN and at least one of the difference amplifier transistors N1 and N2 is conducting, the current in the branch NET1 will be higher than the half of the bias current IBIAS. The transistor P4 tries to mirror this current in the branch NET5 and the transistor N5 tries to force a current equal to 0.4 * IBIAS in it. This means that the voltage at node NET5 will be equal to the operating voltage VDD, the voltage at node NET6 will be 0 and the transistor N6 will be switched off. This means that the comparator will work as described in the prior art. A current flowing through the NET1 branch is higher than the current flowing through the NET2 branch. So when the current mirror CM constituted by the current mirror transistors P1 and P2 tries to force the current going in the NET1 branch on the NET2 branch, the voltage at node NET2 goes up to the operating potential VDD. When the voltage at the non inverting comparator input INP is higher than the voltage at the inverting comparator input INN and at least one of the difference amplifier transistors N1 and N2 is conducting, NET2 is forced to operating potential GND. Indeed, current flowing through the NET2 branch is higher than the current flowing through the NET1 branch. So when the current mirror transistors P1 and P2 of the current mirror try to force the current going in NET1 branch on the NET2 branch, the voltage at node NET2 goes down to operating potential GND. The circuitry added to the comparator of the prior art can either pull down the node NET2 to operating potential GND if the transistor N6 is conducting or can let it floating if the transistor N6 is not conducting. In both cases, it will not modify the comparator behavior.

When the input voltage at the inverting comparator input INN is higher than the input voltage at the non inverting comparator input INP, the voltage at node NET2 is 0 for the standard comparator. So, the state of the transistor N6 will have no effect on node NET2 whatever its gate voltage is.

But when the difference amplifier transistors N1 and N2 are switched off, the added circuitry changes the comparator behavior. Indeed, if no current is flowing through the branch NET1 the voltage at node NET5 is 0, the voltage at node NET6 is equal to the operating potential VDD, the voltage at node NET2 is 0, the voltage at node NET4 is equal to the operating voltage VDD and the voltage at the comparator output OUT is 0. This is the default value at the output OUT of the comparator circuit when both comparator inputs INN and INP are low.

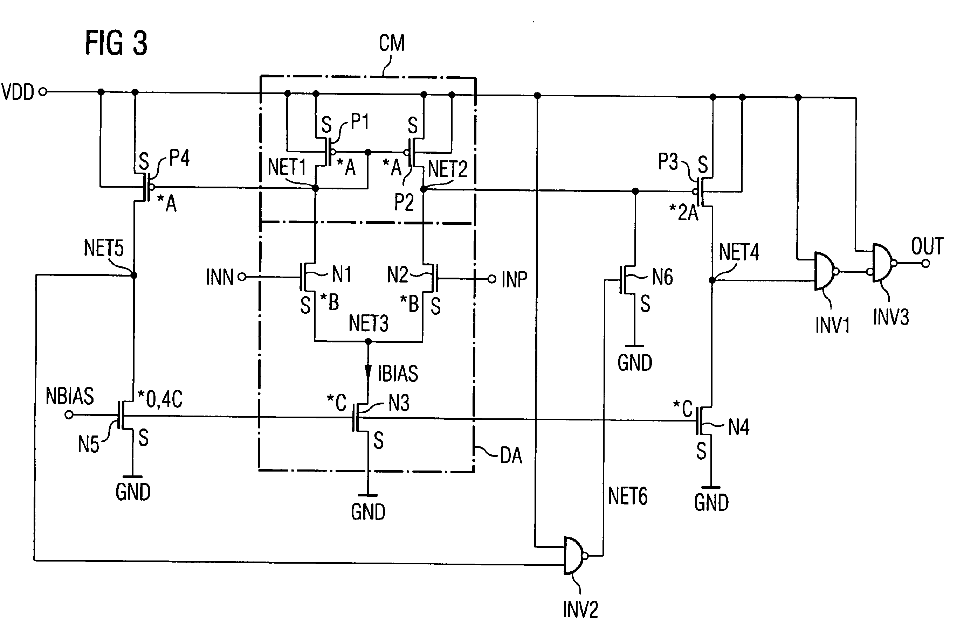

Figure 3 shows how to modify the comparator according to figure 2 in order to change the default comparator value when the input transistors are not conducting from 0 to VDD. A third inverter INV 3 is connected with its input to the output of the first inverter INV1. The output of the inverter INV3 forms now the output OUT of the comparator.

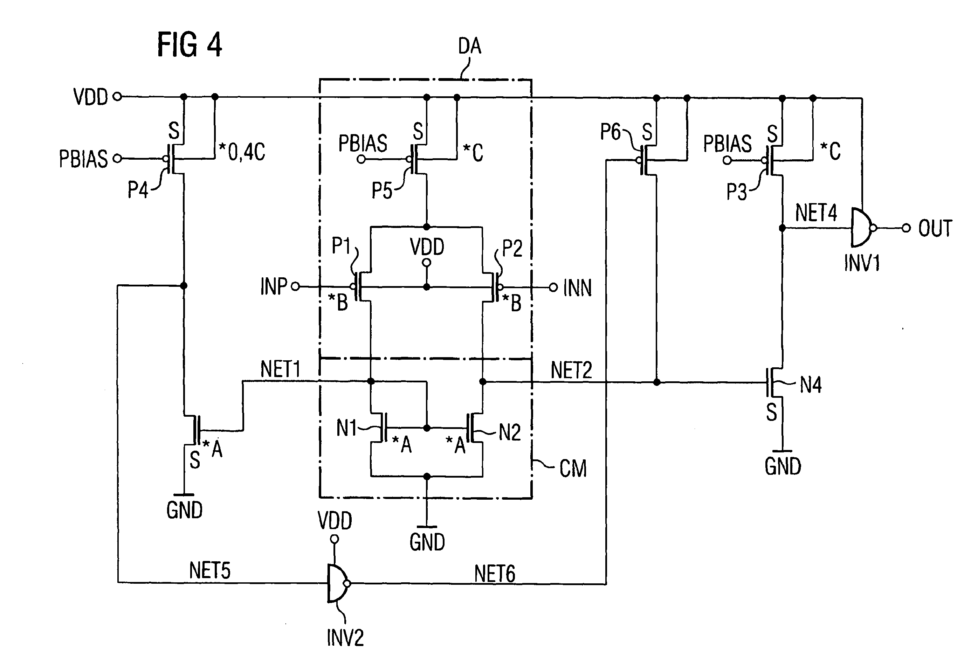

Figure 4 shows a further modified embodiment of the comparator of figure 2 using PMOS input transistors instead of NMOS transistors. The default comparator value is VDD. The current mirror CM comprises in this embodiment two n-channel MOS transistors N1 and N2. The difference amplifier DA contains a first difference amplifier p-channel MOS transistor P1, a second difference amplifier p-channel MOS transistor P2 and a third p-channel MOS transistor P5, which is connected between the operating potential VDD and the first and second difference amplifier transistors P1 and P2. The p-channel transistors P3 and P4 are connected with its gate to a bias control voltage PBIAS.

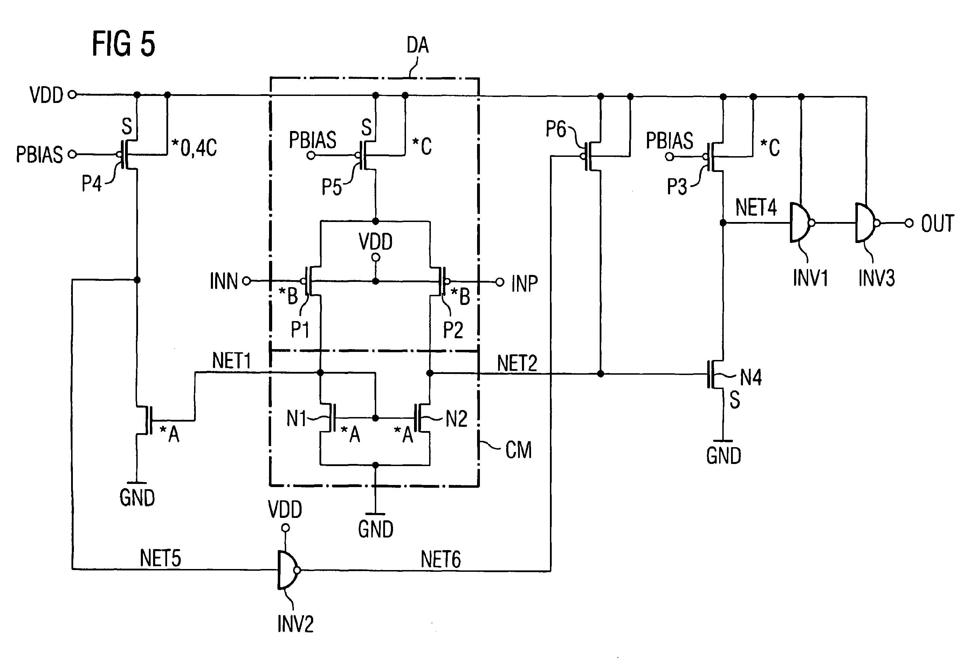

Figure 5 shows how to modify the comparator according to figure 4 in order to change the default comparator value when the input transistors are not conducting from VDD to 0. In this embodiment the difference amplifier DA and the current mirror CM are formed in the same way as the difference amplifier DA and the current mirror CM in the embodiment of figure 4. Just the inputs INP and INN are mixed up. A third inverter INV 3 is connected with its input to the output of the first inverter INV1. The output of the inverter INV3 forms the output OUT of the comparator.

The schematics shown in the figures 3 to 5 are embodiments of the invention.

Having illustrated and described a preferred embodiment for a novel comparator circuit, it is noted that variations and modifications in the circuit can be made without departing from the scope of the appended claims.

### Reference list

- VDD: power supply voltage
- GND: ground or operating potential
- OUT: comparator output
- CM: current mirror
- DA: difference amplifier
- INP: non inverting comparator input
- INN: inverting comparator input
- NBIAS: input for bias voltage
- INV1: first inverter
- INV2: second inverter
- P1: first current mirror transistor
- P2: second current mirror transistor
- P3: PMOS transistor
- P4: PMOS transistor
- P5: PMOS transistor
- N1: first difference amplifier transistor
- N2: second difference amplifier transistor
- N3: first bias transistor
- N4: second bias transistor
- N5: NMOS transistor
- N6: NMOS transistor
- S: source
- NET1-5: branch/node
- *A, *B, *C: transistor size

## Claims

1. Comparator, comprising
a difference amplifier (DA), connected to a current mirror (CM),
a series connection of a first transistor (P4) and a second transistor (N5) connected between a first and a second operating potential (VDD, GND), wherein the control input of said first transistor (P4) is connected to said difference amplifier (DA) and said current mirror (CM),
an inverter (INV2) connected to said first operating potential (VDD) and to the outputs of said first and second transistor (P4, N5), and
a third transistor (N6) connected between said second operating potential (GND) and the output (NET2) of said difference amplifier (DA) and wherein the control input of said third transistor (N6) is connected to the output of said inverter (INV2).

2. Comparator according to claim 1,
wherein the first transistor (P4) is a p-channel MOS-transistor.

3. Comparator according to claim 1 or 2,
wherein the second transistor (N5) is a n-channel MOS-transistor.

4. Comparator according to any preceding claim,
wherein the third transistor (N6) is a n-channel MOS-transistor.

5. Comparator according to any preceding claim,
wherein the difference amplifier (DA) comprises a first difference amplifier transistor (N1; P1) and a second difference amplifier transistor (N2; P2),
wherein the control input of the first difference amplifier transistor (N1; P1) is connected to a first comparator input (INP), and
wherein the control input of the second difference amplifier transistor (N2; P2) is connected to a second comparator input (INN).

6. Comparator according to any preceding claim,
wherein the control input of the second transistor (N5) is connected to a bias input (NBIAS).

7. Comparator according to any of the claims 1 to 5,
wherein the control input of the first transistor (P4) is connected to a bias input (PBIAS).

8. Method for operating a comparator according to claim 5 or 6,
wherein when the first and second difference amplifier transistor (N1, N2) are non conducting, the third transistor (N6) pulls the output (NET2) of the difference amplifier (DA) to the second operating potential (GND).

## Patentansprüche

1. Vergleicher mit folgendem:
einem mit einem Stromspiegel (CM) verbundenen Differenzverstärker (DA),
einer zwischen ein erstes und ein zweites Betriebspotential (VDD, GND) geschalteten Reihenverbindung eines ersten Transistors (P4) und eines zweiten Transistors (N5), wobei der Steuereingang des ersten Transistors (P4) mit dem Differenzverstärker (DA) und dem Stromspiegel (CM) verbunden ist,
einem mit dem ersten Betriebspotential (VDD) und den Ausgängen des ersten und zweiten Transistors (P4, N5) verbundenen Inverter (INV2), und
einem dritten, zwischen das zweite Betriebspotential (GND) und den Ausgang (NET2) des Differenzverstärkers (DA) geschalteten Transistor (N6), und wobei der Steuereingang des dritten Transistors (N6) mit dem Ausgang des Inverters (INV2) verbunden ist.

2. Vergleicher nach Anspruch 1, wobei der erste Transistor (P4) ein MOS-Transistor mit p-leitendem Kanal ist.

3. Vergleicher nach Anspruch 1 oder 2, wobei der zweite Transistor (N5) ein MOS-Transistor mit n-leitendem Kanal ist.

4. Vergleicher nach einem beliebigen vorhergehenden Anspruch, wobei der dritte Transistor (N6) ein MOS-Transistor mit n-leitendem Kanal ist.

5. Vergleicher nach einem beliebigen vorhergehenden Anspruch, wobei der Differenzverstärker (DA) einen ersten Differenzverstärkertransistor (N1; P1) und einen zweiten Differenzverstärkertransistor (N2; P2) umfaßt,
wobei der Steuereingang des ersten Differenzverstärkertransistors (N1; P1) mit einem ersten Vergleichereingang (INP) verbunden ist, und
wobei der Steuereingang des zweiten Differenzverstärkertransistors (N2; P2) mit einem zweiten Vergleichereingang (INN) verbunden ist.

6. Vergleicher nach einem beliebigen vorhergehenden Anspruch, wobei der Steuereingang des zweiten Transistors (N5) mit einem Vorspannungseingang (NBIAS) verbunden ist.

7. Vergleicher nach einem beliebigen der Ansprüche 1 bis 5, wobei der Steuereingang des ersten Transistors (P4) mit einem Vorspannungseingang (PBIAS) verbunden ist.

8. Verfahren zum Betreiben eines Vergleichers nach Anspruch 5 oder 6, wobei, wenn der erste und zweite Differenzverstärkertransistor (N1, N2) nichtleitend sind, der dritte Transistor (N6) die Ausgabe (N2) des Differenzverstärkers (DA) auf das zweite Betriebspotential (GND) zieht.

## Revendications

1. Comparateur, comprenant :
un amplificateur différentiel (DA), connecté à un miroir de courant (CM),
un montage en série d'un premier transistor (P4) et d'un deuxième transistor (N5) connectés entre un premier et un deuxième potentiel (VDD, GND) de fonctionnement, dans lequel l'entrée de commande du premier transistor (P4) est connectée à l'amplificateur différentiel (DA) et au miroir de courant (CM),
un inverseur (INV2) connecté au premier potentiel (VDD) de fonctionnement et aux sorties des premier et deuxième transistor (P4, N5), et
un troisième transistor (N6) connecté entre le deuxième potenteil (GND) de fonctionnement et la sortie (NET2) de l'amplificateur différentiel (DA) et dans lequel l'entrée de commande du troisième transistor (N6) est connectée à la sortie de l'inverseur (INV2).

2. Comparateur selon la revendication 1,
dans lequel le premier transistor (P4) est un transistor MOS à canal P.

3. Comparateur selon la revendication 1 ou 2,
dans lequel le deuxième transistor (N5) est un transistor MOS à canal N.

4. Comparateur selon l'une quelconque des revendications précédentes,
dans lequel le troisième transistor (N6) est un transistor MOS à canal N.

5. Comparateur selon l'une quelconque des revendications précédentes,
dans lequel l'amplificateur différentiel (DA) comprend un premier transistor (N1 ; P1) d'amplificateur différentiel et un deuxième transistor (N2 ; P2) d'amplificateur différentiel,
dans lequel l'entrée de commande du premier transistor (N1 ; P1) d'amplificateur différentiel est connectée à une première entrée (INP) de comparateur, et
dans lequel l'entrée de commande du deuxième transistor (N2 ; P2) d'amplificateur différentiel est connectée à une deuxième entrée (INN) de comparateur.

6. Comparateur selon l'une quelconque des revendications précédentes,
dans lequel l'entrée de commande du deuxième transistor (N5) est connectée à une entrée (NBIAS) de polarisation.

7. Comparateur selon l'une quelconque des revendications 1 à 5,
dans lequel l'entrée de commande du premier transistor (P4) est connectée à une entrée (PBIAS) de polarisation.

8. Procédé de commande d'un comparateur selon la revendication 5 ou 6,
dans lequel quand les premier et deuxième transistors (N1, N2) d'amplificateur différentiel sont non conducteurs, le troisième transistor (N6) attire la sortie (NET2) de l'amplificateur différentiel (DA) vers le deuxième potentiel (GND) de fonctionnement.
